# EUROPEAN PATENT APPLICATION

(11) **EP 2 418 860 A1**
(43) Date of publication of application: **15.02.2012**
(21) Application number: 09843098.6
(22) Date of filing: 13.08.2009
(51) Int. Cl.: H04N 13/02

(54) **IMAGE SENSOR FOR GENERATING STEREOSCOPIC IMAGES**

(30) Priority: 06.04.2009 KR 20090029391
(71) Applicant: Asic Bank Co., Ltd., Gyeonggi-do 463-816 (KR)
(72) Inventor: PARK, Eun Hwa, Yongin-si Gyeonggi-do 448-160 (KR); KANG, Hie Minn, Seongnam-si Gyeonggi-do 462-824 (KR)
(74) Representative: Beck & Rössig European Patent Attorneys
(86) International application number: PCT/KR2009/004536
(87) International publication number: WO 2010/117111

(57) **Abstract**

The present invention relates to an image sensor for generating stereoscopic images. According to the present invention, the image sensor for generating stereoscopic images comprises: a left image sensor which is arranged to generate a left eye image of a subject to be photographed; a right image sensor which is spaced apart from the left image sensor to generate the right eye image of the subject; and a driving circuit unit which drives the left eye image sensor and the right eye image sensor. The left eye image sensor, the right eye image sensor, and the driving circuit unit are all disposed on a single wafer. According to the present invention, the image sensor for generating stereoscopic images can be applied to a device such as a mobile terminal, portable stereo camera or stereo camcorder.

## Description

### TECHNICAL FIELD

The present invention relates to an image sensor for generating stereoscopic images, and more specifically, to a wafer-level image sensor for generating stereoscopic images, which facilitates mechanical alignment and is suitable for miniaturization.

### BACKGROUND ART

Stereo vision arises from binocular disparity, in which the left/right eyes' different positions (the difference: 6.5cm) leads to two different projections onto the retinas of the two eyes even when the same subject is viewed.

Generally, stereo camera systems, which mechanically align two 2-dimensional (2-D) cameras, where an optical system is added to each of two image sensors that are independently manufactured, are required to generate stereoscopic images. Stereo camera systems are Classified into parallel, convergence, and horizontal-moving stereo camera systems according to methods of aligning two cameras.

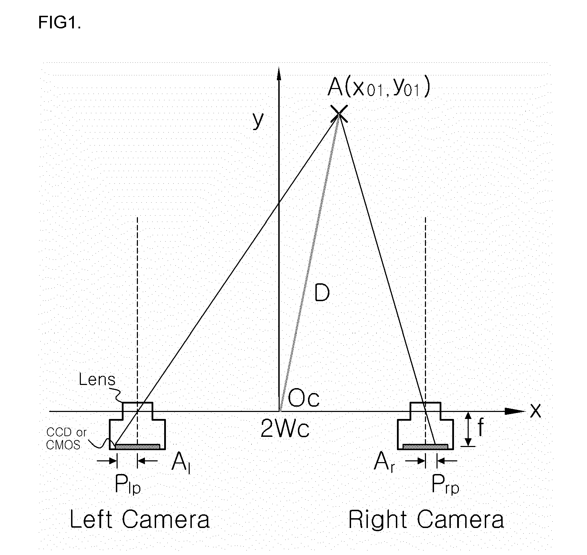

FIG. 1 is a view illustrating a parallel stereo camera system.

Referring to FIG. 1, two cameras are always fixed at the same position regardless of a subject's position and are located in parallel. This configuration has advantages in terms of manufacturability and cost.

According to the parallel stereo camera system, an image processing means is added at the rear end of a camera for the control of a viewing angle and the correction of mechanical alignment according to a focusing distance.

In using a parallel stereo camera, if a subject is close such that the difference between two images is large, convergence occurs, and if a subject is far away such that the difference between two images is small, the stereo effect is deteriorated. To control a viewing angle, left/right images are stored in a memory, and the space between the corresponding points in left/right images is found. The space between two images is narrowed when the space between the corresponding points in left/right images is greater than a reference value, and is widened when the space between the corresponding points in left/right images is less than a reference value, thereby preventing the convergence and also enhancing the stereo effect.

Although two cameras are mechanically aligned very precisely, errors occur in a Y-axis direction (vertical direction), X-axis direction (horizontal direction), and Z-axis direction (subject's direction). Accordingly, left/right images are stored in a memory, the corresponding points of the left/right images are found, and then only common sections of the left/right images are displayed on a display device.

However, the following limitations cannot be solved despite any image processing.

In particular, when the same subject is captured with left/right cameras, but a 3-dimensional alignment is not perfect in the X-axis, Y-axis, and Z-axis directions, the direction (Z) cannot be captured. Accordingly, there are many difficulties for mass production, and the stereo effect is reduced. In addition, since only common sections are displayed, an image loss occurs and the image size becomes smaller.

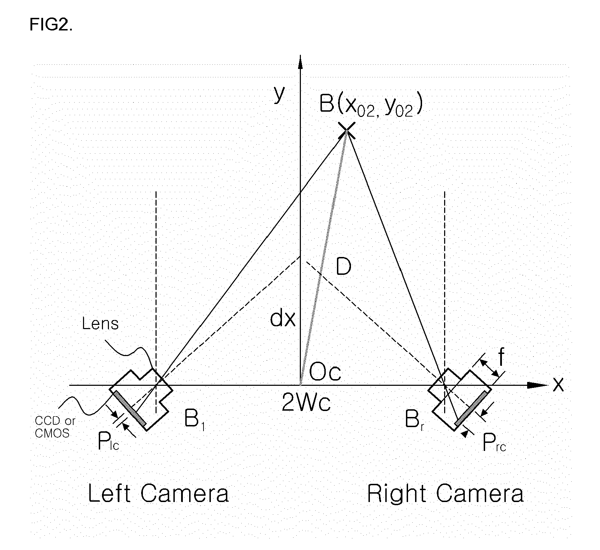

FIG. 2 is a view illustrating a convergence stereo camera system.

A convergence stereo camera system is a scheme that controls a camera direction (Z-axis direction) to the central portion of a subject, as with human eyes. This scheme has barely been used because images other than the main subject have such a great left/right image difference that the images cannot be represented in existing stereo display devices. More specifically, human eyes can sense only specific subject when fixed on the specific subject. However, since a monitor should display areas other than a specific subject, and the subject is different depending on a person viewing the monitor, the visual depth of all images should be given. A convergence stereo camera cannot output data for giving visual depth to all areas, and thus has not been widely used as a stereo camera scheme.

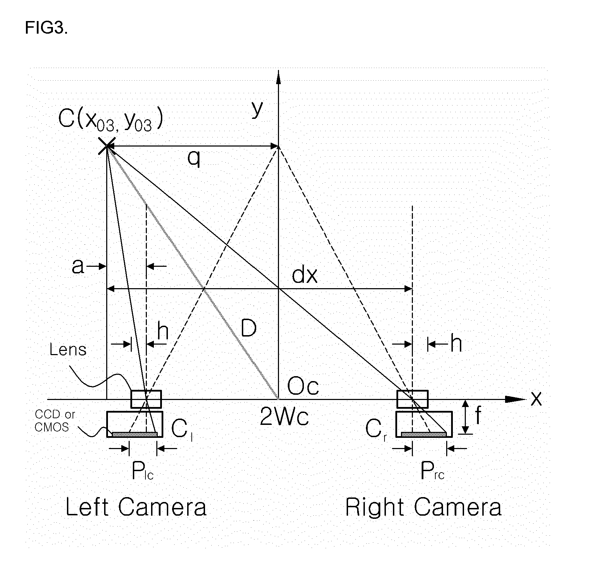

FIG. 3 is a view illustrating a horizontal-moving stereo camera system.

Referring to FIG. 3, a horizontal-moving stereo camera is similar to a parallel stereo camera, but is a scheme that horizontally moves a camera according to a distance of a subject. That is, the space between left/right cameras is widened when a subject is close, and the space between left/right cameras is narrowed when a subject is far away, to mechanically perform a viewing angle control. A horizontal-moving stereo camera is better than a parallel stereo camera with respect to visual depth, but has disadvantages in cost, size, reliability, and productivity, and is therefore used in only high-priced products. Moreover, a horizontal-moving stereo camera is usually used for a broadcast because the stereo camera is horizontally moved according to a zoom/focus distance.

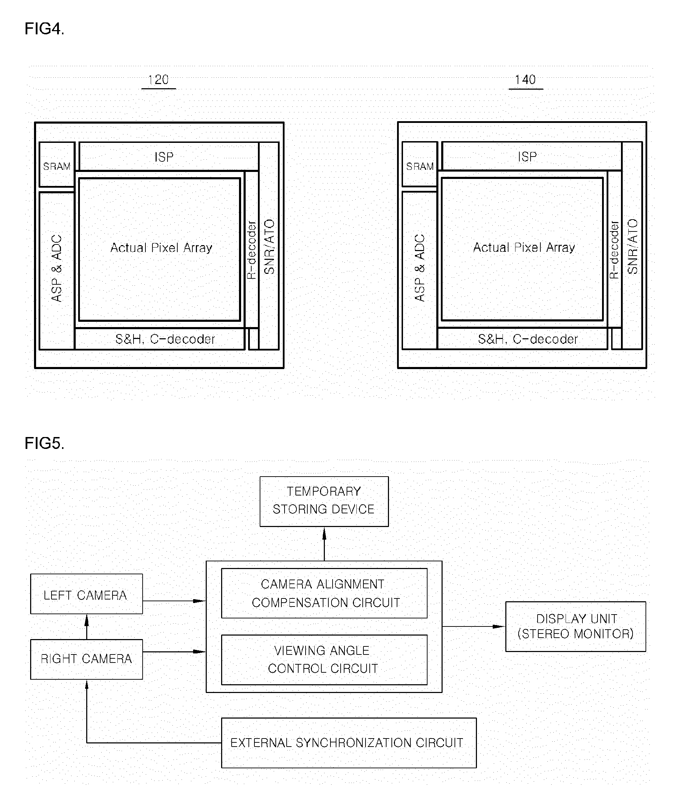

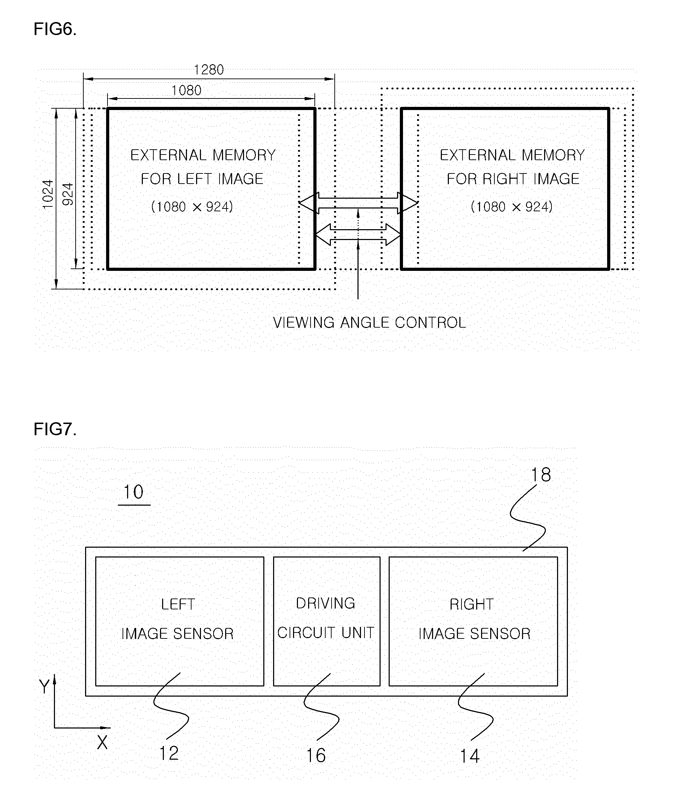

FIG. 4 is a view illustrating two image sensors with mutually separated structures, which are used in a typical stereo camera. FIG. 5 is a view illustrating a driving device for driving the two image sensors with mutually separated structures of FIG. 4. FIG. 6 is a view illustrating an image loss that occurs in a process of driving the two image sensors with mutually separated structures of FIG. 4.

Referring to FIGS. 4 to 6, typical stereo camera systems commonly have two 2-D cameras with mutually separated structures and which are mechanically aligned and used. This leads to the following limitations: errors may occur in an alignment process; manufacturing cost and manufacturability are problematic because of the requirement of a means for time synchronization between two 2-D cameras; and the stereo camera system has such a large size that the stereo camera system is difficult to apply to a mobile terminal, portable stereo camera, or stereo camcorder.

### DISCLOSURE OF INVENTION

### PROBLEM TO BE SOLVED BY THE INVENTION

The present invention provides an image sensor for generating stereoscopic images which is applicable to a mobile terminal, a portable stereo camera, or a stereo camcorder.

The present invention also provides an image sensor for generating stereoscopic images which is suitable for a mass production, miniaturization, and low pricing.

The present invention also provides an image sensor for generating stereoscopic images which may facilitate mechanical alignments in X-axis, Y-axis, and Z-axis directions.

The present invention also provides an image sensor for generating stereoscopic images in which it is unnecessary to form an additional circuit for adjusting time synchronization outside a wafer.

### MEANS FOR SOLVING PROBLEM

To achieve the above technical object, an image sensor for generating stereoscopic images according to an embodiment of the present invention includes: a left image sensor generating a left eye image of a subject; a right image sensor disposed apart from the left image sensor and generating a right eye image of the subject; and a driving circuit unit driving the left image sensor and right image sensor, wherein the left image sensor, right image sensor, driving circuit unit are formed on one wafer.

At least a portion of the driving circuit unit may be disposed in a space between the left image sensor and right image sensor.

The left image sensor and right image sensor may be automatically aligned at the wafer level with no alignment compensation circuit outside the wafer.

Time synchronization between electric signals read in the left image sensor and right image sensor may be automatically performed at the wafer level with no additional time synchronization circuit.

The left and right image sensors may have a width greater than a display to which the stereoscopic images are output.

The image sensor may be a Complementary Metal-Oxide Semiconductor (CMOS) or Charge-Coupled Device (CCD).

### EFFECT OF THE INVENTION

The image sensor for generating stereoscopic images according to the present invention has a structure in which two image sensors are formed on one wafer, thereby significantly enhancing the stereo effect and facilitating a mechanical alignment of two image sensors even without an additional alignment compensation circuit disposed outside a wafer.

Accordingly, an additional circuit for adjusting time synchronization is not necessary to be formed outside a wafer.

Moreover, it is possible to realize a mass production, miniaturization, and low pricing of stereo cameras.

The image sensor for generating stereoscopic images which is applicable to a mobile terminal, a portable stereo camera, or a stereo camcorder is provided.

### BRIEF DESCRIPTION OF DRAWINGS

FIG. 1 is a view illustrating an alignment method of a parallel stereo camera;
FIG. 2 is a view illustrating an alignment method of a convergence stereo camera;
FIG. 3 is a view illustrating an alignment method of a horizontal-moving stereo camera;
FIG. 4 is a view illustrating two image sensors with mutually separated structures which are used in typical stereo cameras;
FIG. 5 is a view illustrating a driving device for driving the two image sensors with mutually separated structures of FIG. 4;
FIG. 6 is a view illustrating an image loss that occurs in a process of driving the two image sensors with mutually separated structures of FIG. 4;
FIG. 7 is a view illustrating an image sensor for generating stereoscopic images according to an embodiment of the present invention;
FIG. 8 is a view illustrating an example of a structure in which the image sensor of FIG. 7 is mounted on a printed circuit board;
FIG. 9 is a view illustrating a configuration with left and right image sensors, which are included in an image sensor for generating stereoscopic images according to an embodiment of the present invention, and a circuit for driving the image sensors;
FIG. 10 is a view illustrating a driving concept of an image sensor for generating stereoscopic images according to an embodiment of the present invention; and
FIG. 11 is a view illustrating an effective image area according to driving of an image sensor for generating stereoscopic images according to an embodiment of the present invention.

### EXPLANATIONS OF LETTERS OR NUMERALS

| | | | |
|---|---|---|---|
| 10: | IMAGE SENSOR | 12: | LEFT IMAGE SENSOR |
| 14: | RIGHT IMAGE SENSOR | 16: | DRIVING CIRCUIT UNIT |
| 18: | WAFER | 20: | PRINTED CIRCUIT BOARD |
| 22: | WIRE | | |

### BEST MODE FOR CARRYING OUT THE INVENTION

Preferred embodiments of the present invention will be described below in more detail with reference to the accompanying drawings.

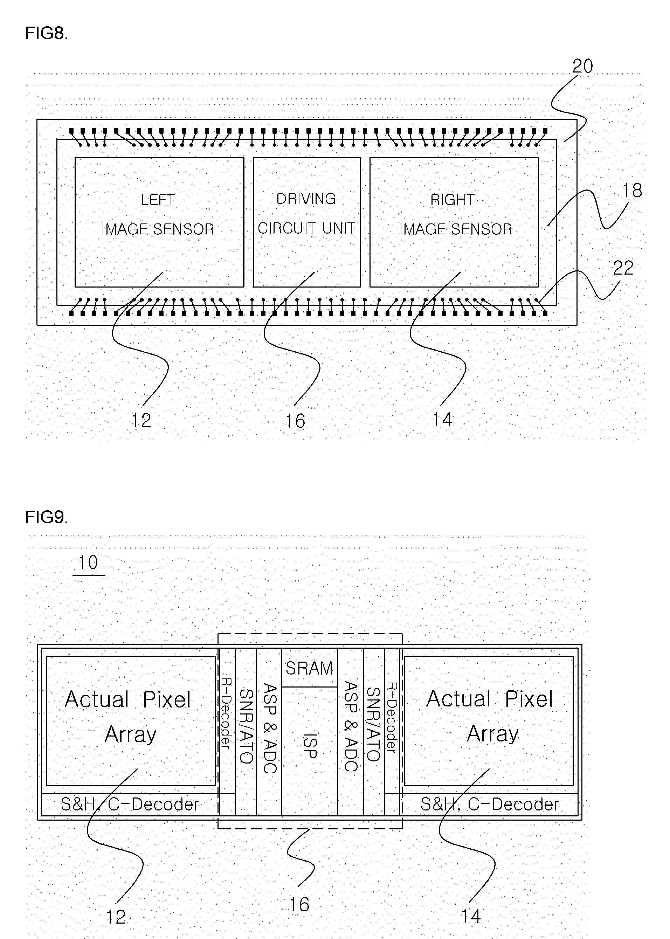

FIG. 7 is a view illustrating an image sensor for generating stereoscopic images according to an embodiment of the present invention. FIG. 8 is a view illustrating an example of a structure in which the image sensor of FIG. 7 is mounted on a printed circuit board.

Referring to FIGS. 7 and 8, an image sensor 10 for generating stereoscopic images according to an embodiment of the present invention includes a left image sensor 12, a right image sensor 14, and a driving circuit unit 16, wherein the image sensor 10 is mounted on a printed circuit board 20 in a flip-chip bonding manner using a wire 22.

The image sensor used in an embodiment of the present invention may be a Complementary Metal Oxide Semiconductor (CMOS) image sensor, a Charge Coupled Device (CCD) image sensor, or a contact image sensor. Hereinafter, the case of using a CMOS image sensor among several kinds of image sensors will be described exemplarily. Although described below, a CMOS image sensor can operate with a single source having about 3.3 V like a general CMOS Large Scale Integration (LSI), and thus have advantages in terms of power consumption and built-in signal processing functions. This will be described in detail during the description of the driving circuit unit 16.

The left image sensor 12 is a means for generating a left eye image of a subject. Each pixel in the left image sensor 12 may have one, three, or four transistors and a photodiode for receiving light from a subject.

The right image sensor 14 is disposed on a single wafer 18 and spaced apart from the left image sensor 12. The right image sensor 14 is a means for generating a right eye image of the subject.

That is, the left image sensor 12 and right image sensor 14 are formed on the same wafer 18 and disposed apart from each other, thereby representing the stereo effect.

This will now be described in more detail in comparison with the related art.

Referring to FIGS. 1 to 3, in the related art, stereo cameras are configured using two 2-D cameras for capturing only planar images. According to typical configurations, the 2-D cameras have two image sensors, respectively, which are separated from each other as shown in FIG. 4. Two image sensors are physically separated to be formed on different wafers, causing problems in an alignment and time synchronization as described below. However, an image sensor 10 for generating stereoscopic images according to an embodiment of the present invention is configured in such a way that two image sensors 12 and 14 are mounted on one wafer 18. By adding an optical system to the image sensor, a stereo camera which facilitates time synchronization and mechanical alignments of X-, Y-, and Z-axes is implemented.

More specifically, a stereo camera is typically implemented by respectively manufacturing left and right cameras and mechanically aligning them. This causes a size of the implemented stereo camera to be increased. In addition, left and right cameras cannot be focused on the same point like human eyes because of the inherent limitation in an alignment process even though the left and right cameras are precisely aligned. And also, as shown in FIG. 5, an additional camera alignment compensation circuit should be necessarily provided.

The image sensor 10 for generating stereoscopic images according to the embodiment of the present invention has a configuration in which two image sensors 12 and 14 are mounted on a single wafer 18. That is, the two image sensors 12 and 14 are mounted on the single wafer 18 and an optical system and a driving circuit unit are added thereto, thereby significantly reducing the size of a stereo camera. Since the two image sensors 12 and 14 are formed on the single wafer 18, alignment errors in X and Y axes are controlled in nanometer units, and alignment errors in Z axis is significantly reduced, as shown in FIG. 7. Accordingly, the left and right image sensors 12 and 14 always are focused on the same point, thereby further increasing the stereo effect than the related art methods. A 3-dimensional alignment can be easily realized by matching only an optical axis (Z axis) of a lens constituting an optical system, thereby enabling a mass production, miniaturization, and low pricing of stereo cameras and significantly enhancing the stereo effect.

Also, a typical stereo camera using two 2-D cameras necessarily need an additional circuit for adjusting time synchronization between left and right cameras. However, the image sensor 10 for generating stereoscopic images according to the embodiment of the present invention has a structure in which the left image sensor 12 and right image sensor 14 are integrally formed on the single wafer 18, and thus time synchronization between electric signals read in the left image sensor 12 and right image sensor 14 is automatically done at a wafer level with no additional time synchronization circuit. Accordingly, an additional circuit for adjusting time synchronization is not necessary to be formed outside a wafer.

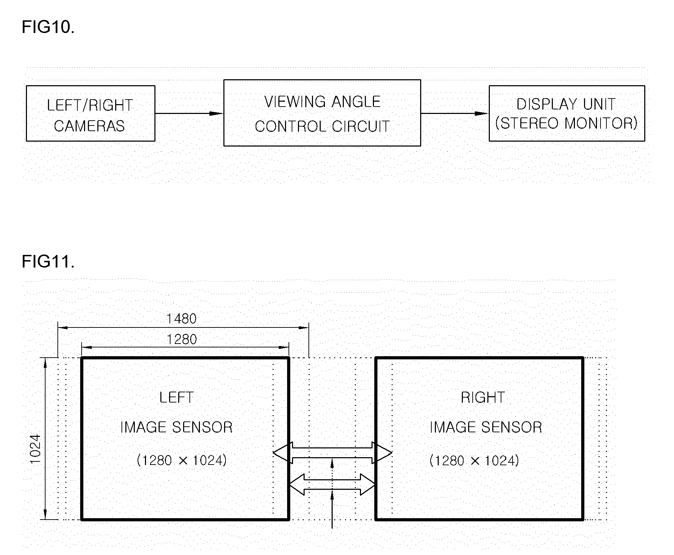

The change of a diving circuit depending on the structure of an image sensor according to an embodiment of the present invention can be seen with reference to FIGS. 5 and 10.

The driving circuit unit 16 is disposed on the wafer 18between the left image sensor 12 and the right image sensor 14. The driving circuit unit 16 is a means for driving the left image sensor 12 and right image sensor 14.

This will now be described in more detail in comparison with the related art.

Referring to FIG. 4, in the related art, each of two image sensors 120 and 140 separated from each other has a structure in which an image sensing area is disposed in the center thereof, and driving circuits such as an Analog Digital Converter (ADC) and Image Signal Processor (ISP) are disposed in edges outside the image sensing area. The typical structure, however, has a problem in that a light-receiving area is reduced.

However, referring to FIGS. 7 to 9, the image sensor 10 for generating stereoscopic images according to the embodiment of the present invention has a structure in which the left image sensor 12 and right image sensor 14 are disposed on the single wafer 18 and spaced apart from each other, and a driving circuit unit 16 is disposed on an empty region of the wafer 18 between the two image sensors 12 and 14. That is, the two image sensors 12 and 14 are disposed apart from each other to thereby increase the stereo effect, and also a driving circuit unit 16 including an ADC and an ISP is disposed on the wafer 18 therebetween to thereby significantly reduce the size of a conductive image sensor without decrease in the size of a light-receiving area.

In the above, the configuration where the driving circuit unit 16 is disposed on the wafer 18 between the left image sensor 12 and right image sensor 14 has been described as an example. However, this is merely exemplified, and thus the driving circuit unit 16 may be disposed at all or a portion of peripheral regions of the left and right image sensors 12 and 14.

As described in brief above, a CMOS image sensor may be manufactured through a general CMOS LSI manufacturing process. Accordingly, a CMOS image sensor may be implemented into one chip having various functions such as signal processing function and input and output function as well as an image sensor function. The CMOS image sensor has all functions of a camera within a single chip. That is, the CMOS image sensor enables a "camera on chip" to be realized, thereby miniaturizing a camera module.

In general, an image loss occurs due to an alignment error and a viewing angle control during a process of generating stereoscopic images using two image sensors. However, such an image loss does not occur in a case of using the image sensor according to the embodiment of the present invention.
This will now be described in more detail in comparison with the related art.

Referring to FIG. 6, in the related art, an image loss caused by a viewing angle control process is added to an image loss due to an alignment error of two image sensors. FIG. 6 illustrates a case in which the resolution of an original image is degraded from 1280×1024 to 1080×924.

However, referring to FIG. 11, such an image loss can be prevented by setting the left image sensor 12 and the right image sensor 14 forming the image sensor 10 according to the embodiment of the present invention to have widths greater than a display to which stereoscopic images are output.

More particularly, first, the left image sensor 12 and right image sensor 14 according to the embodiment of the present invention are mechanically fixed to the single wafer 18, and thus an image loss caused by alignment error does not occur. Second, as described above, the left image sensor 12 and right image sensor 14 are set to have widths greater than a commercially available display, and thus an image loss caused by a viewing angle control also does not occur. That is, the related art image sensors support only TV/PC monitors with a standard size (640×480, 720×480, 800×600, 1280×1024, 1024×768, 1280×720, 1920×1080), whereas the image sensor according to the embodiment of the present invention is set to have a horizontal axis (X-axis) area greater than a standard monitor size so as to compensate for left and right images which are lost during control of a viewing angle, and to horizontally move using only lens. FIG. 11 illustrates a case in which a display size is 1280×1024 pixels and a left image sensor 12 and right image sensor 14 have 1480×1024 pixels. Resultingly, according to such pixel configuration, an image loss does not occur on a display.

A stereo camera using related art image sensor structures stores left and right eye images in an external memory and finds out the corresponding positions in the left and right eye image. The typical stereo camera performs a viewing angle control by changing read start points of left and right eye images, which are stored in an external memory, to narrow a space between the two images if the space between the corresponding points in left/right images is greater than a reference value, and to widen the space between the two images, which are stored in an external memory, if the space between the corresponding points in left/right images is less than a reference value. Thus, the left eye and right eye images are delayed by about 1 frame (33 msec).

According to the embodiment of the present invention, however, in the case of arranging the two image sensors 12 and 14 on the single wafer 18 and driving the image sensors 12 and 14 with the driving circuit unit 16, it is possible to control a viewing by changing read start points of the left and right image sensors 12 and 14 without storing the left and right eye images in a memory. Therefore, an external memory is not required, and an image delay does not take place.

As described in detail above, the image sensor 10 for generating stereoscopic images according to the embodiment of the present invention has a configuration in which the two image sensors 12 and 14 are mounted on the single wafer 18. Applying such image sensor 10 to a stereo camera can significantly enhance the stereo effect and facilitate mechanical alignments without an additional alignment compensation circuit. Accordingly, an additional circuit for adjusting time synchronization is not necessary to be formed outside a wafer. Furthermore, a mass production, miniaturization, and low pricing of stereo cameras can be enabled.

The image sensor 10 for generating stereoscopic images according to the embodiment of the present invention is widely applicable to various fields for a stereoscopic image generation. For example, a stereo camera with a light, thin, short, and small structure may be implemented by adding an optical system including lens to the image sensor 10 for generating stereoscopic images according to the embodiment of the present invention. A stereo camcorder, laparoscope, and mobile terminal using the stereo camera may also be implemented. The stereo camera may also be applied to a space detecting device for a human-computer interface.

The inventive concept of the present invention is described with reference to the accompanying drawings, however, the above-disclosed subject matter is to be considered illustrative and not restrictive. It will be understood by those skilled in the art that various changes in form and details may be made therein without departing from the spirit and scope of the present invention.

## Claims

1. An image sensor for generating stereoscopic images, comprising:
a left image sensor generating a left eye image of a subject;
a right image sensor disposed apart from the left image sensor and generating a right eye image of the subject; and
a driving circuit unit driving the left image sensor and the right image sensor,
wherein the left image sensor, the right image sensor, and the driving circuit unit are formed on a single wafer.

2. The image sensor of claim 1, wherein at least a portion of the driving circuit unit is disposed in a space between the left image sensor and the right image sensor.

3. The image sensor of claim 1, wherein the left and right image sensors have widths greater than a display to which the stereoscopic images are output.

4. The image sensor of claim 1, wherein the image sensor is a Complementary Metal-Oxide Semiconductor (CMOS) or Charge-Coupled Device (CCD) image sensor.
